# EUROPÄISCHE PATENTSCHRIFT

(11) **EP 1 649 521 B1**
(45) Veröffentlichungstag und Bekanntmachung des Hinweises auf die Patenterteilung: **19.12.2012**
(21) Anmeldenummer: 04739806.0
(22) Anmeldetag: 11.06.2004
(51) Int. Cl.: H01L 31/0352, H01S 5/34, H01L 29/12

(54) **QUANTENTOPFSTRUKTUR**
QUANTUM WELL STRUCTURE
STRUCTURE A PUITS QUANTIQUE

(30) Priorität: 31.07.2003 DE 10335443
(43) Veröffentlichungstag der Anmeldung: 26.04.2006
(73) Patentinhaber: Humboldt-Universität zu Berlin, 10099 Berlin (DE)
(72) Erfinder: MASSELINK, William, Ted, DE-12205 Berlin (DE); SEMTSIV, Mykhaylo, Petrovych, DE-12627 Berlin (DE)
(74) Vertreter: Fischer, Uwe
(86) Internationale Anmeldenummer: PCT/EP2004/006314
(87) Internationale Veröffentlichungsnummer: WO 2005/022651

(56) Entgegenhaltungen:
- GB-A- 2 352 087
- US-A1- 2002 075 924
- US-A1- 2002 162 995
- US-A1- 2003 052 317
- US-A1- 2003 059 998
- MIKHAILOV S A: "A New Type of Tunable Solid-State Far-Infared Lasers" CONF LASERS ELECTRO OPT EUR TECH DIG, 14. September 1998 (1998-09-14), Seiten 92-92, XP010306688
- WALTER G ET AL: "Room-temperature continuous photopumped laser operation of coupled InP quantum dot and InGaP quantum well InP–InGaP–In(AlGa)P&nd ash;InAlP heterostructures" APPLIED PHYSICS LETTERS, AMERICAN INSTITUTE OF PHYSICS. NEW YORK, US, Bd. 79, Nr. 13, 24. September 2001 (2001-09-24), Seiten 1956-1958, XP012028957 ISSN: 0003-6951
- ASAHI H: "SELF-ORGANIZED QUANTUM WIRES AND DOTS IN III-V SEMICONDUCTORS" ADVANCED MATERIALS, VCH VERLAGSGESELLSCHAFT, WEINHEIM, DE, Bd. 9, Nr. 13, 3. November 1997 (1997-11-03), Seiten 1019-1026, XP000721510 ISSN: 0935-9648
- BELYAEV A E ET AL: "Positively charged defects associated with self-assembled quantum dot formation" APPLIED PHYSICS LETTERS, AMERICAN INSTITUTE OF PHYSICS. NEW YORK, US, Bd. 76, Nr. 24, 12. Juni 2000 (2000-06-12), Seiten 3570-3572, XP012025529 ISSN: 0003-6951
- PHILLIPS J. ET AL: "Self-Assembled InAs-GaAs Quantum-Dot Intersubband Detectors", IEEE JOURNAL OF QUANTUM ELECTRONICS, vol. 35, no. 6, 1 June 1999 (1999-06-01), pages 936-943, XP011052226, IEEE SERVICE CENTER, PISCATAWAY, NJ
- MIKHAILOV S.A. ET AL: "Terahertz wave amplification, stimulated by dc electric current, in grating coupled low-dimensional electron systems", APPLIED PHYSICS LETTERS, vol. 71, no. 10, 8 September 1997 (1997-09-08), pages 1308-1310, XP012018525, AIP, AMERICAN INSTITUTE OF PHYSICS, MELVILLE, NY

## Beschreibung

Die vorliegende Erfindung betrifft ein Verfahren zum Detektieren von Photonen mit einer Quantentopfstruktut

Eine Quantenstopfstruktur umfasst zwei Barrierenschichten aus Halbleitermaterial, und eine zwischen den beiden Barrierenschichten angeordnete sog. Quantentopfschicht (Quantum-Well-Schicht), die ebenfalls aus einem Halbleitermaterial hergestellt ist. Die Dicke der Quantentopfschicht, also ihre Ausdehnung in Normalenrichtung (d.h. in der Stapelrichtung der Schichten) ist meist deutlich geringer als ihre laterale Ausdehnung (d.h. senkrecht zur Stapelrichtung der Schichten) und beträgt typischerweise nur wenige nm.

Das elektrische Verhalten eines Halbleitermaterials lässt sich mit dem sog. Bändermodell beschreiben. Dieses besagt, dass den Elektronen des Halbleitermaterials verschiedene Energiebereiche, die sog. Energiebänder, zur Verfügung stehen, innerhalb derer sie im Wesentlichen beliebige Energiewerte annehmen können. Verschiedene Bänder können durch eine Bandlücke, d.h. einen Energiebereich mit Energiewerten, welche die Elektronen nicht annehmen können, voneinander getrennt sein. Die Anzahl der Elektronen, die ein Band aufnehmen kann, ist begrenzt. Für ein Halbleitermaterial sind das energetisch höchstliegende voll besetze Band, das sog. Valenzband, und das energetisch über dem Valenzband liegende, leere Leitungsband sowie die Bandlücke zwischen ihnen von besonderer Bedeutung.

In Quantentopfstrukturen wie sie bspw. für Quantentopf-Infrarot-Photodetektoren, kurz QWIPs (Quantum-Well-Infrared-Photodetectors), oder Quanten-Kaskaden-Laser, kurz QCLs (Quantum-Cascade-Lasers), Verwendung finden, sind die Halbleitermaterialen für die Barrierenschichten und die Quantentopfschicht so gewählt, dass das Leitungsband des Barrierenmaterials energetisch höher liegt als das des Quantentopfmaterials. Diese Wahl führt dazu, dass die Elektronen der Quantentopfschicht nicht ohne weiteres in die Barrierenschichten eindringen können, so dass sie in der Quantentopfschicht eingeschlossen sind.

In der Quantentopfschicht wird das Verhalten der in ihr eingeschlossenen Elektronen aufgrund der geringen Dicke der Schicht (wenige Nanometer) durch quantenmechanische Effekte bestimmt. Ein wesentlicher Effekt ist dabei, dass die Elektronen in einem Energieband der Quantentopfschicht nicht mehr jeden beliebigen Energiewert innerhalb des Energiebereiches des Bandes annehmen können, sondern auf die Energiewerte bestimmter Energieniveaus festgelegt sind. Eine Änderung der Elektronenenergie erfolgt daher nicht kontinuierlich, sondern sprunghaft von einem Energieniveau zu einem anderen. Nur dann, wenn der Energiezuwachs oder die Energieabgabe, die ein Elektron erfährt, genau der Differenz der Energiewerte zweier Energieniveaus entspricht, kann es von einem zum anderen Energieniveau wechseln. Übergänge von einem Energieniveau zu einem anderen innerhalb ein und desselben Bandes werden Intersubbandübergänge genannt.

In QWIPs und QCLs macht man sich die Intersubbandübergänge für das Detektieren oder Emittieren von Licht mit einer bestimmten Wellenlänge, also der Absorption oder Emission von Photonen mit einer bestimmten Photonenenergie, zunutze. Die dafür verwendeten Quantentopfschichten sind sehr homogen, da sich in homogenen Quantentopfschichten die Energien der Energieniveaus durch geeignete Wahl der Dicke der Quantentopfschicht genau einstellen lassen, und damit auch die Energie der zu absorbierenden bzw. der emittierten Photonen. Die Energiewerte der Energieniveaus in den Energiebändern einer Quantentopfschicht reagieren dabei sehr empfindlich auf Änderungen der Schichtdicke. Quantenmechanische Prinzipien, sog. Auswahlregeln, erlauben die Absorption bzw. Emission in derart homogenen Quantentopfschichten jedoch nur dann, wenn das zu absorbierende Photon bzw. das emittierte Photon ein elektrisches Feld besitzt, dessen Polarisationsrichtung in Normalenrichtung der Quantentopfschicht verläuft. Da das elektrische Feld eines Photons senkrecht in Bezug auf seine Ausbreitungsrichtung polarisiert ist, bedeutet dies, dass Licht welches in Normalenrichtung der Quantentopfschicht einfällt, nicht detektiert werden kann (QWIP) bzw. dass kein Licht in Normalenrichtung emittiert wird (QCL). Die Detektion bzw. Emission in Normalenrichtung wäre jedoch von Vorteil, da sie das Ein- und Auskoppeln von Licht in die bzw. aus der Quantentopfstruktur vereinfachen würde.

Es gibt daher verschiedene Ansätze, die Absorption von in Normalenrichtung einfallendem Licht bzw. die Emission von Licht in Normalenrichtung zu ermöglichen.

In US 2002/0162995 werden dazu QDIPs (Quantum Dot Infrared Photodetectors) offenbart.

In US 6 423 980 ist bspw. vorgeschlagen, über einer Quantentopfstruktur für einen QWIP ein Beugungsgitter anzuordnen, die einen großen Teil des in Normalenrichtung einfallenden Lichtes aus der Normalenrichtung ablenkt, so dass es sich in der Quantentopfstruktur nicht in Normalenrichtung ausbreitet und demzufolge absorbiert werden kann. Eine tatsächliche Absorption von Photonen, die sich in der Quantentopfstruktur in Normalenrichtung bewegen, findet jedoch nicht statt.

Ein anderer Ansatz sieht vor, die Ursache für das beschriebene Absorptions- bzw. Emissionsverhalten zu beseitigen. Die Homogenität der Quantentopfschicht bedeutet auch, dass eine homogene Verteilung der Elektronendichte in der Schicht vorliegt. Diese Homogenität in der Verteilung der Elektronendichte ist die Ursache dafür, dass in Normalenrichtung der Quantentopfschicht einfallende Photonen in der Quantentopfschicht nicht absorbiert werden können. Es wurde daher bspw. in J. Phillips et al. "Self-assembled InAs-GaAs quantum dot intersubband detectors", IEEE Journal of Quantum Electronics 35, Seiten 936-943, 1999 vorgeschlagen, Quantenpunkte (sog. Quantendots), also quasi-eindimensionale Strukturen, in die Quantentopfschicht eines QWIPs einzuführen, um die Homogenität der Schicht aufzuheben. Das Aufheben der Homogenität durch die Quantenpunkte hat zur Folge, dass in der entsprechenden Quantentopfschicht auch die Absorption von in Normalenrichtung einfallendem Licht, also von Photonen, deren elektrisches Feld nicht in Normalenrichtung der Schicht polarisiert ist, möglich ist. Jedoch erschweren bspw. Variationen in der Größe der in der Quantentopfschicht angeordneten Quantenpunkte das genaue Einstellen der Energiewerte der Energieniveaus in der Quantentopfschicht, und damit das Einstellen der zu absorbierenden Photonenenergie. Außerdem müssen die Quantenpunkte aus energetischen Gründen relativ weit voneinander beabstandet sein, um zu einer signifikanten Aufhebung der Homogenität zu führen. Der große Abstand führt aber zu einer relativ geringen Flächendichte der Elektronen, da diese in den Bereichen der Quantenpunkte lokalisiert sind, d.h. die Elektronendichte ist im Bereich der Quantenpunkte hoch und dazwischen niedrig, was sich nachteilig auf das Absorptions- bzw. Emissionsverhalten der Quantentopfschicht auswirkt. Schließlich führen die Quantenpunkte auch zu einer Beschränkung in der minimal möglichen Dicke der Quantentopfschicht, was die Einstellmöglichkeiten für die Energien der zu absorbierenden Photonen eingrenzt.

Es ist daher Aufgabe der vorliegenden Erfindung, ein verbessertes Verfahren zu schaffen, welches die Absorption von in Normalenrichtung einfallendern Licht ermöglicht.

Diese Aufgabe wird durch ein Verfahren nach Anspruch 1, gelöst. Die abhängigen Ansprüche enthalten vorteilhafte Ausgestaltungen des erfindungsgemäßen Verfahrens.

Eine Quantentopfstruktur umfasst eine zwischen zwei Barrierenschichten angeordnete Quantentopfschicht. Sie zeichnet sich dadurch aus, dass mindestens eine der Barrierenschichten Nanostrukturen in Form von Quantenpunkten umfasst, die eine ohne die Nanostrukturen vorhandene laterale Homogenität der Barrierenschicht, d.h. eine Homogenität in den Richtungen, die senkrecht zur Stapelrichtung der Schichten in der Quantentopfstruktur verlaufen, aufheben oder modulieren. Die in der Quantentopfstruktur verwendeten Nanostrukturen weisen vorzugsweise in mindestens einer Ausdehnungsrichtung eine Ausdehnung von maximal 50 nm auf. Weiter vorzugsweise liegt die Abmessung im Bereich von 5 bis 15 nm.

Die Quantentopfstruktur ermöglicht die Absorption bzw. Emission von Photonen in Normalenrichtung der Quantentopfschicht, ohne das genaue Einstellen der Energiewerte der Energieniveaus in der Quantentopfschicht, und damit das Einstellen der zu absorbierenden Photonenenergie, wesentlich zu erschweren. Da in der Quantentopfstruktur keine Quantenpunkte in der Quantentopfschicht selbst vorhanden zu sein brauchen, verringert sich die Flächendichte der Elektronen der Quantentopfschicht nicht wesentlich. Auch gibt es in der Quantentopfstruktur keine wesentliche Beschränkung in der minimal möglichen Dicke der Schicht, so dass ein hoher Flexibilitätsgrad beim Einstellen der Energiewerte zu absorbierender oder zu emittierender Photonen möglich ist.

Die Quantentopfstruktur beruht auf den nachfolgend dargelegten Überlegungen:

Die typischen Materialien, die in den Barrierenschichten und den Quantentopfschichten Verwendung finden, weisen eine kristalline Struktur auf, d.h. ihre Atome weisen eine regelmäßige Anordnung auf; sie bilden die sog. Gitterstruktur des kristallinen Materials. Wenn sich die Gitterstruktur des Materials im Wesentlichen ungestört fortsetzt, so ist es als homogenes Volumenmaterial anzusehen. Streckungen und Stauchungen der Gitterstruktur als Ganzes sollen hierbei im Wesentlichen nicht als Störungen angesehen werden.

Wird die Homogenität der Quantentopfschicht wie im Stand der Technik durch Quantenpunkte gestört, um eine Absorption oder Emission von in Normalenrichtung der Schicht einfallenden Photonen zu ermöglichen, so beeinflusst dieser Eingriff in die Quantentopfschicht die Einstellung der Energiewerte der Energieniveaus in einer schwer vorhersehbaren Weise.

Die Erfindung basiert nun auf der Erkenntnis, dass eine Absorption oder Emission von in Normalenrichtung der Schicht einfallenden Photonen auch durch das Aufheben oder Modulieren der Homogenität mindestens einer der Barrierenschichten ermöglicht werden kann. Die Ursache hierfür ist, dass die Homogenität der Verteilung der Elektronendichte in der Quantentopfschicht, die das Absorbieren von in Normalenrichtung einfallenden Photonen bzw. das Emittieren von Photonen in Normalenrichtung verhindert, nicht nur von der Homogenität der Gitterstruktur der Quantentopfschicht abhängt, sondern auch von den Bedingungen an den Grenzflächen zu den Barrierenschichten. Die Bedingungen an den Grenzflächen hängen jedoch auch von der Struktur der Barrierenschichten ab. Durch das Aufheben oder Modulieren der Homogenität mindestens einer Barrierenschicht kann daher die Homogenität der Verteilung der Elektronendichte in der Quantentopfschicht in lateraler Richtung aufgehoben oder moduliert werden, ohne die Gitterstruktur der Quantentopfschicht wesentlich zu beeinflussen. Entsprechend bleiben auch die Energiewerte der Energieniveaus vom Aufheben oder Modulieren der Homogenität mindestens einer der Barrierenschichten im Wesentlichen unbeeinflusst, so dass das gezielte Einstellen der Energiewerte nicht beeinträchtigt wird. Außerdem wird die Flächendichte der Elektronen nicht derart stark beeinflusst, wie durch Quantenpunkte, die in der Quantentopfschicht angeordnet sind.

Als Quantenpunkte sollen hier Nanostrukturen angesehen werden, deren Abmessungen in allen lateralen Richtungen weniger als 100 nm, insbesondere weniger als 50 nm, betragen und vorzugsweise im Bereich von 5 bis 15 nm liegen. Die Abmessung der Quantenpunkte in vertikaler Richtung betragen nicht mehr als ca. 10 nm, insbesondere liegen sie im Bereich von 1 bis 5 nm und vorzugsweise im Bereich von 2 bis 3 nm.

Besonders gut lassen sich zum Herstellen der selbstorganisierten Quantenpunkte Materialien verwenden, deren Gitterstruktur gegenüber der Gitterstruktur der Barrierenschicht deutlich gestreckt ist. Je gestreckter die Gitterstruktur ist, desto größer ist der Abstand der Atome im Gitter voneinander. Ein Maß für den Abstand, den die Atome in einer Gitterstruktur voneinander haben, ist die sog. Gitterkonstante der Gitterstruktur. In einer vorteilhaften Ausgestaltung der Quantenpunkte sind diese daher aus einem Material hergestellt, das eine deutlich größere Gitterkonstante aufweist, als das Material der Barrierenschicht.

In einer weiteren Ausgestaltung der Quantentopfstruktur ist die Barrierenschicht als Aluminiumarsenidschicht (AlAs-Schicht) mit Indiumarsenidinseln (InAs-InseIn) als Nanostrukturen oder als Indium-phosphidschicht (InP-Schicht) mit Indiumarsenidinseln (InAs-InseIn) als Nanostrukturen ausgebildet. Die Verarbeitung der genannten Materialien ist in der Halbleitertechnologie weit verbreitet, so dass in ihrer Handhabung beim Herstellen der Quantentopfstruktur auf einen reichen Erfahrungsschatz zurückgegriffen werden kann.

Um ihre Effizienz der Quantentopfstruktur beim Absorbieren von Photonen zu steigern, können in einer Weiterbildung der Quantentopfstruktur zwei oder mehr Quantentopfschichten vorhanden sein, die jeweils mindestens durch eine Barrierenschicht voneinander getrennt sind.

Weitere Merkmale, Eigenschaften und Vorteile der vorliegenden Erfindung ergeben sich aus der nachfolgenden Beschreibung von Ausführungsbeispielen, wobei auf die beiliegenden Zeichnungen 1-5 Bezug genommen wird, die Versckiendene Quantentopfstrukturen zeigen.

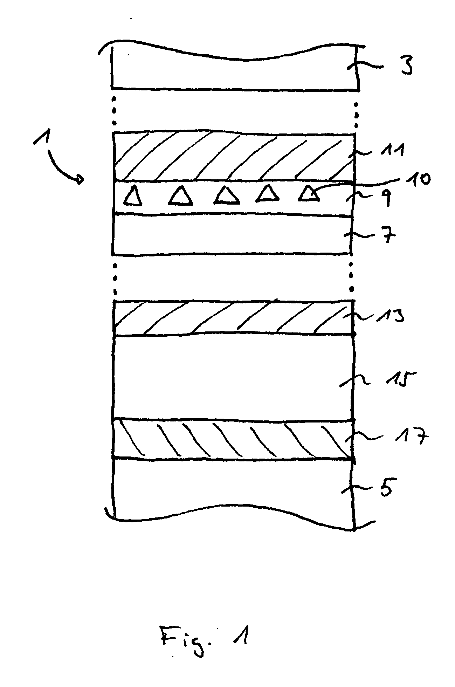

In Fig. 1 ist als erstes Ausführungsbeispiel schematisch eine spezielle Form des QWIPs, nämlich ein sog. Gamma-Valley-Normal-Incidence-Infrared Photodetctor, dargestellt, der im Folgenden als GV-QWIP bezeichnet wird. Die Bezeichnung "Gamma-Valley" deutet auf einen bestimmten Bereich des Energiebandes, in dem die Intersubbandübergänge stattfinden, hin. Sie soll hier nicht weiter erläutert werden. Im GV-QWIP ist zwischen einer oberen Kontakt-und Deckschicht 3 und einer unteren Kontaktschicht 5 eine Quantentopfstruktur angeordnet, in der eine Absorption von Photonen stattfindet, die zu einer messbaren Spannung im Detektor führt. Die obere Kontaktschicht 3 und die untere Kontaktschicht 5 sind jeweils als siliziumdotierte Gallium-Arsenid-Schicht (GaAs:Si) mit einer Dicke von ca. 500 nm ausgeführt.

Die Quantentopfstruktur ist als periodische Struktur mit 30 Perioden 1 ausgebildet, von denen in Figur 1 nur eine stellvertretend dargestellt ist. Jede Periode 1 umfasst eine Quantentopfschicht 7 mit einer Schichtdicke von ca. 4 nm, eine über der Quantentopfschicht 7 angeordnete Barrierenschicht 9 mit einer Schichtdicke von ca. 2,5 nm und eine über der Barrierenschicht 9 angeordnete Abstandshalterschicht 11 (Spacer Layer) mit einer Schichtdicke von ca. 25 nm, die eine weitere Barrierenschicht darstellt. Die Abstandshalterschicht 11 ist im vorliegenden Ausführungsbeispiel als Aluminium-Gallium-Arsenid-Schicht (AlGaAs) ausgebildet. Jede Quantentopfschicht 7 ist somit zwischen zwei Barrierenschichten angeordnet, nämlich zwischen der Barrierenschicht 9, die an die Oberseite der Quantentopfschicht 7 angrenzt, und der Abstandshalterschicht 11 der nächst tiefer liegenden, d.h. näher am Substrat liegenden, Periode 1.

Die Quantentopfschicht 7 ist als siliziumdotierte Gallium-Arsenid-Schicht ausgebildet und stellt die eigentliche Detektorschicht der Periode dar, d.h. in ihr findet die Absorption der Photonen statt. Um die Absorption von Photonen, die in Normalenrichtung der Quantentopfschicht 7 einfallen, zu ermöglichen, enthält die Barrierenschicht 9 Indium-Arsenid-Inseln 10 als Nanostrukturen. Die Barrierenschicht 9 selbst ist als Aluminium-Arsenid-Matrix für die Indiumarsenidinseln 10 ausgebildet. Die laterale Ausdehnung der Inseln beträgt weniger als 50 nm, vorzugsweise 5 bis 15 nm und ihre Ausdehnung in Normalenrichtung der Barrierenschicht 9 ca. 1 - 5 nm, vorzugsweise 2 - 3 nm. Die Inseln 10 sind dabei so in der Barrierenschicht 9 angeordnet, dass ihr Abstand zur Quantentopfschicht 7 im Bereich von 0,3 bis 2 nm liegt. Vorzugsweise sollte der Abstand jedoch im Bereich von 0,5 bis 1 nm liegen. Im vorliegenden Ausführungsbeispiel beträgt der Abstand ca. 1 nm oder etwas weniger.

Damit auch die Quantentopfschicht 7 der untersten Periode 1 zwischen zwei Barrierenschichten angeordnet ist, schließt sich an die Unterseite dieser untersten Quantentopfschicht 7 eine untere Abstandshalterschicht 13 an, die wie die übrigen Abstandshalterschichten 11 als Aluminium-Gallium-Arsenid-Schicht ausgebildet ist. Substratseitig folgt auf die Abstandshalterschicht 13 eine siliziumdotierte Gallium-Arsenid-Schicht 15 als weitere Abstandshalterschicht, die nicht als Barrierenschicht dient. Zwischen der siliziumdotierten Gallium-Arsenid-Schicht 15 und dem Substrat (nicht dargestellt) ist darüber hinaus eine siliziumdotierte Indium-Gallium-Phosphid-Schicht (InGaP:Si) 17 vorhanden, die beim Herstellen der Quantentopfstruktur als Ätzstop dient.

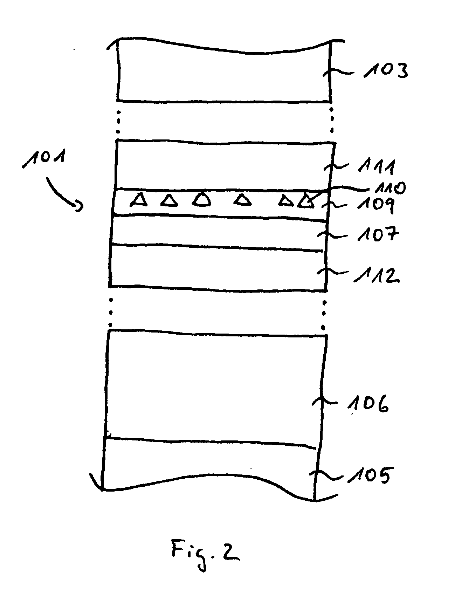

Fig. 2 zeigt als zweites Ausführungsbeispiel für die Quantentopfstruktur eine alternative Ausgestaltung des GV-QWIPs. Im in Fig. 2 dargestellten GV-QWIP ist wie im ersten Ausführungsbeispiel zwischen einer oberen Kontakt- und Deckschicht 103 und einer unteren Kontaktschicht 105 eine Quantentopfstruktur angeordnet. Die obere Kontaktschicht 103 ist in vorliegenden Ausführungsbeispiel als siliziumdotierte Indium-Gallium-Arsenid-Schicht (InGaAs:Si) mit einer Dicke von ca. 500 nm ausgeführt, während die untere Kontaktschicht 105 als siliziumdotierte Indium-Phosphid-Schicht ausgebildet ist, die gleichzeitig das Substrat des GV-QWIP darstellt. Zwischen dem Substrat 105 und der Quantentopfstruktur ist eine ca. 200 nm dicke Indium-Gallium-Arsenid-Schicht als Pufferschicht 106 angeordnet.

Die Quantentopfstruktur ist in Normatenrichtung als periodische Struktur mit 50 Perioden 101 ausgebildet, von denen in Figur 2 nur eine stellvertretend dargestellt ist. Jede Periode 101 des zweiten Ausführungsbeispiels umfasst eine Quantentopfschicht 107 mit einer Schichtdicke von ca. 4 nm, über der eine Barrierenschicht 109 mit einer Schichtdicke von mindestens ca. 2 bis 2,5 nm angeordnet ist. Über der Barrierenschicht 109 befindet sich wie im GV-QWIP des ersten Ausführungsbeispiels eine Abstandshalterschicht 111 mit einer Schichtdicke von ca. 25 nm, die eine weitere Barrierenschicht darstellt. Im Unterschied zum GV-QWIP des ersten Ausführungsbeispiels umfasst jede Periode 107 darüber hinaus eine weitere gleichzeitig als Barrierenschicht dienende Abstandshalterschicht 112 mit einer Dicke von ca. 25 nm, die substratseitig an die Quantentopfschicht 107 angrenzt. Die über der Barrierenschicht 109 angeordnete Abstandshalterschicht 111 ist im Unterschied zum ersten Ausführungsbeispiel als Indium-Aluminium-Arsenid-Schicht ausgebildet, ebenso die substratseitig an die Quantentopfschicht 107 angrenzende Abstandshalterschicht 112.

Die Quantentopfschicht 107 ist im zweiten Ausführungsbeispiel als siliziumdotierte Indium-Galium-Arsenid-Schicht (InGaAs:Si) ausgebildet und stellt die eigentliche Detektorschicht der Periode 101 dar. Die Barrierenschicht 109 ist als Aluminium-Arsenid-Matrix ausgebildet, in die Indium-Arsenid-Inseln 110 eingebettet sind. Die laterale Ausdehnung der Inseln beträgt weniger als 50 nm, vorzugsweise 5 bis 15 nm. Die Inseln 110, die in Normalenrichtung der Barrierenschicht 109 eine Ausdehnung von 1 bis 5 nm, vorzugsweise von 2 bis 3 nm, aufweisen, sind dabei so in der Barrierenschicht 109 angeordnet, dass ihr Abstand zur Quantentopfschicht deutlich weniger als 1 nm beträgt und insbesondere zwischen 0,5 und 0,8 nm liegt.

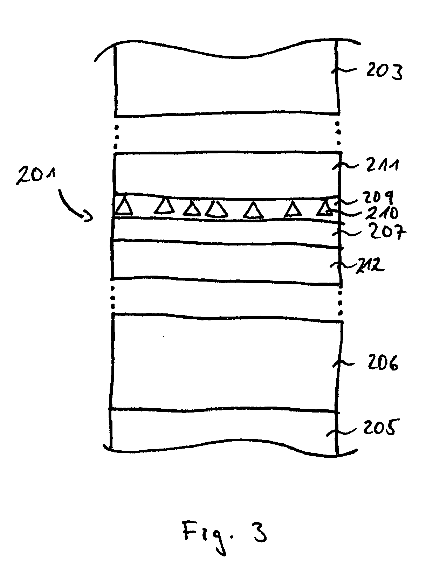

Ein drittes Ausführungsbeispiel für die Quantentopfstruktur ist in Fig. 3 gezeigt. Das Ausführungsbeispiel stellt einen sog. X-Valley-Normal-Incidence-Infrared-Photodetector, im Folgenden kurz XV-QWIP genannt, dar. Die Bezeichnung "X-Valley" deutet wie die Bezeichnung "Gamma-Valley" auf einen bestimmten Bereich des Energiebandes, in dem die Intersubbandübergänge stattfinden, hin.

Im in Fig. 3 dargestellten XV-QWIP ist eine Quantentopfstruktur zwischen einer oberen Kontakt- und Deckschicht 203 mit einer Dicke von ca. 500 nm und einer unteren Kontaktschicht 205, die gleichzeitig das Substrat des XV-QWIP darstellt, angeordnet. Beide Kontaktschichten 203, 205 sind im dritten Ausführungsbeispiel als siliziumdotierte Gallium-Phosphid-Schicht ausgeführt. Zwischen dem Substrat 205 und der Quantentopfstruktur ist zudem eine weitere, ca. 200 nm dicke siliziumdotierte Gallium-Phosphid-Schicht als Pufferschicht 206 angeordnet.

Die Quantentopfstruktur ist wie im GV-QWID des zweiten Ausführungsbeispiels in Normalenrichtung als periodische Struktur mit 50 Perioden 201 ausgebildet, von denen in Figur 3 nur eine stellvertretend dargestellt ist. Jede Periode 201 des dritten Ausführungsbeispiels umfasst eine Quantentopfschicht 207 mit einer Schichtdicke von ca. 2,5 nm. Ober der Quantentopfschicht 207 ist eine Barrierenschicht 209 und darüber eine Abstandshalterschicht 211, die eine weitere Barrierenschicht darstellt, mit einer Schichtdicke von ca. 25 nm angeordnet. Wie beim GV-QWIP des zweiten Ausführungsbeispiels umfasst jede Periode 207 darüber hinaus eine weitere gleichzeitig als Barrierenschicht dienende Abstandshalterschicht 212 mit einer Dicke von ca. 25 nm, die substratseitig an die Quantentopfschicht 207 angrenzt. Beide Abstandshalterschichten 211, 212 sind als Gallium-Phosphid-Schichten (GaP) ausgebildet.

Im XV-QWID des dritten Ausführungsbeispiels ist die Quantentopfschicht 207 als siliziumdotierte Aluminium-Phosphid-Schicht (AlP:Si) ausgebildet und stellt die eigentliche Detektorschicht der Periode 201 dar. Die Barrierenschicht 209 ist als Indium-Phosphidschicht oder als (Al,Ga)P-Matrix, d.h. aus einer Mischung von Aluminium-Phosphid und Gallium-Phosphid, ausgebildet, in die Indium-Arsenid-Inseln 210 eingebettet sind. Die Mischung (Al,Ga)P soll dabei auch die Grenzfälle von reinem AlP oder reinem GaP umfassen. Die laterale Ausdehnung der Inseln beträgt auch in diesem Ausführungsbeispiel weniger als 50 nm, vorzugsweise 5 bis 15 nm, ihre Ausdehnung in Normalenrichtung der Barrierenschicht 209 liegt zwischen 1 und 5 nm, vorzugsweise zwischen 2 und 3 nm. Die Inseln 210 sind dabei so in der Barrierenschicht 209 angeordnet, dass ihr Abstand zur Quantentopfschicht 7 im Bereich von 0 bis 2 nm liegt. Dabei sollte der Abstand der Inseln 210 von der Quantentopfschicht möglichst gering sein, also möglichst nahe Null liegen. Im vorliegenden Ausführungsbeispiel erstrecken sich die Inseln 210 in Normalenrichtung im Wesentlichen durch die gesamte Barrierenschicht 209.

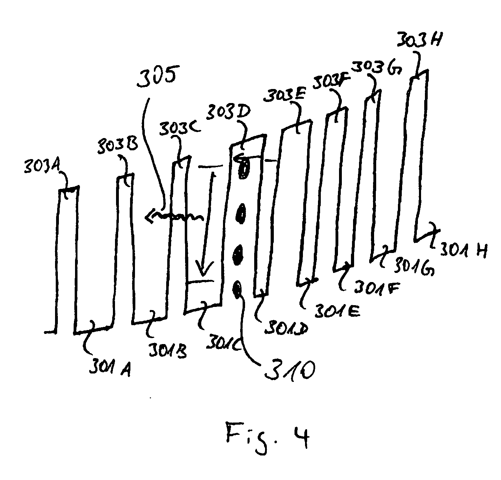

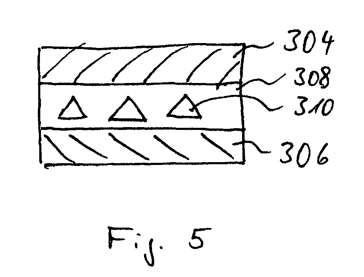

Fig.4 zeigt als Biepiel, das das Verständnis der Erfindung erleichtert schematisch einen Al_{0.3}Ga_{0.7}As/GaAs Quanten-Kaskaden-Laser, QCL. Der gezeigte QCL umfasst eine periodische Struktur, von der eine Periode in Fig.4 dargestellt ist. Diese Periode kann sich in einem QCL bis zu mehreren Dutzend Mal wiederholen. Jede Periode des QCL umfasst eine Anzahl einander abwechselnd angeordneter Quantentopfschichten 301A - 301 H und Barrierenschichten 303A - 303H. Im vorliegenden Ausführungsbeispiel sind die Quantentopfschichten 301A - 301 H als Gallium-Arsenid-Schichten und die Barrierenschichten 303A - 303C sowie die Barrierenschichten 303E - 303H als Aluminium-Gallium-Arsenid-Schichten (AlGaAs) ausgebildet. Die Zusammensetzung und die Struktur der Barrierenschicht 303D wird weiter unten mit Bezug auf Fig. 5 erläutert.

In einem QCL werden Intersubbandübergänge von Elektronen in der Quantentopfschicht 301C zum Emittieren von Photonen mit einer bestimmten Photonenenergie ausgenutzt. Für das Emittieren von Photonen sind dabei vor allem die Quantentopfschichten 301C, 301 D sowie die Barrierenschicht 303D von Bedeutung. Ein Elektron, das sich in der Quantentopfschicht 301D auf einem Energieniveau mit einem hohen Energiewert befindet, kann in einem quantenmechanischen Prozess durch die Barrierenschicht 303D hindurch in die Quantentopfschicht 303C gelangen, man spricht hierbei davon, dass das Elektron die Barrierenschicht 303D durchtunnelt. Die physikalischen Eigenschaften der Schichten 301C, 301 D und 303D sind so gewählt, dass das Elektron nach dem Durchtunneln der Barrierenschicht 303D in der Quantentopfschicht 303C von dem Energieniveau mit dem hohen Energiewert auf ein Energieniveau mit einem niedrigen Energiewert übergeht, wobei es ein Photon 305 aussendet, dessen Energie der Differenz der beiden Energiewerte entspricht.

In der Barrierenschicht 303D sind Nanostrukturen 310 angeordnet, welche die Homogenität der Barrierenschicht 303D in lateraler Richtung und somit die laterale Homogenität der Verteilung der Elektronendichte In der Quantentopfschicht 303C modulieren. Die Barrierenschicht 303D ermöglicht so das Emittieren von Photonen in Normalenrichtung der Quantentopfschicht 303C, ohne die Homogenität der Quantentopschicht 303C selber aufzuheben oder zu modulieren.

Die Barrierenschicht 303D ist in Fig. 5 im Detail gezeigt. Zwischen zwei Aluminium-Gallium-Arsenid-Schichten 304 und 306 mit einer Dicke von ca. 1,4 nm bzw. 0,8 nm ist eine Aluminium-Arsenid-Schicht 308 angeordnet, die als Matrix für Indium-Arsenid-Inseln 310 als Nanostrukturen dient. Die Indium-Arsenid-Inseln 310 weisen in Normalenrichtung der Aluminium-Arsenid-Schicht 308 eine Ausdehnung von ca. 0,6 nm auf. Sie sind derart in die Aluminium-Arsenid-Schicht 308 eingebettet, dass sie zu den Aluminium-Gallium-Arsenid-Schichten 304 und 306 jeweils einen Abstand von ca. 0,6 nm aufweisen. In Summe beträgt die Dicke der Aluminium-Arsenid-Schicht 308 daher ca. 1,8 nm, so dass die Barrierenschicht 303D insgesamt eine Dicke von ca. 4 nm aufweist.

In den beschriebenen Ausführungsbeispielen sind die lateralen Abmessungen der Nanostrukturen so gewählt, dass sie in lateraler Richtung nicht größer als ca. 50 nm sind und vorzugsweise im Bereich von 5 bis 15 nm liegen. Derart kleine Strukturen können auch als Quantenpunkte angesehen werden. Die optimalen Abmessungen der Quantenpunkte können dabei vom verwendeten Material abhängen.

In den beschriebenen Ausführungsbeispielen sind Aluminium-Arsenid-Barrierenschichten mit Indium-Arsenid-Inseln als Nanostrukturen sowie (In, Ga,Al)P-Schichten (d.h. Schichten aus einer Mischung von Indium-, Gallium- und Aluminium-Phosphid, wobei die Mischung auch reines Indium-, Gallium- oder Aluminium-Phosphid sein kann) mit Indium-Arsenid-Inseln als Nanostrukturen beschrieben. Die vorliegende Erfindung ist jedoch nicht auf Verfahren mit dieser Materialauswahl beschränkt. Vielmehr eignen sich eine Vielzahl von Materialkombinationen, die vorzugsweise derart gewählt sind, dass das für die Inseln verwendete Material eine deutlich größere Gitterkonstante aufweist, als das für die Barrierenschicht verwendete Material, da dies die Selbstorganisation der Inseln im Barrierenmaterial fördert.

Die in den Ausführungsbeispielen beschrieben Schichten können in bekannter Weise bspw. mittels Molekularstrahlepitaxie (MBE, Molecular Beam Epitaxie) oder mittels chemischer Gasphasenabscheidung (CVD) erzeugt werden.

## Patentansprüche

1. Verfahren zum Detektieren von Photonen einer bestimmten Wellenlänge mit einem Quantum-Well-Infrarot-Photodetektor, wobei bei dem Verfahren die Photonen in einer Quantentopfstruktur mit einer zwischen zwei Barrierenschichten (9, 11; 109, 112; 209, 212) angeordneten Quantentopfschicht (7; 107; 207) absorbiert werden,
- wobei die Quantentopfschicht (7; 107; 207) als Absorptionsschicht zum Absorbieren der Photonen ausgestaltet ist und die Absorption von Photonen in Normalenrichtung der Quantentopfschicht ermöglicht wird und
- wobei die Absorption der Photonen durch Intersubbandübergänge in Subbändern eines Energiebands der Quantentopfschicht erfolgt,
wobei
mindestens eine der Barrierenschichten (9, 11; 109, 112; 209, 212) selbstorganiserte Quantenpunkte (10; 110; 210) umfasst, deren laterale Ausdehnung weniger als 100 nm beträgt und deren Abmessungen in vertikaler Richtung nicht mehr als 10 nm betragen, und eine ohne die Quantenpunkte (10; 110; 210) vorhandene laterale Homogenität der Barrierenschicht (9; 109; 209;) von den selbstorganisierten Quantenpunkten derart aufgehoben oder moduliert wird, dass dadurch die Homogenität der Elektronendichteverteilung in der Quantentopfschicht (7; 107; 207) in lateraler Richtung aufgehoben oder moduliert wird und dadurch die Photonen in Normalenrichtung der Quantentopfschicht absorbiert werden.

2. Verfahren nach Anspruch 1,
**dadurch gekennzeichnet, dass**
ein Quantum-Well-Infrarot-Photodetektor verwendet wird, bei dem die Quantenpunkte (10; 110; 210) eine laterale Ausdehnung von weniger als 50 nm besitzen.

3. Verfahren nach Anspruch 2,
**dadurch gekennzeichnet, dass**
ein Quantum-Well-Infrarot-Photodetektor verwendet wird, bei dem die Abmessungen der Quantenpunkte (10; 110; 210) in lateraler Richtung im Bereich von 5 bis 15 nm liegen.

4. Verfahren nach einem der Ansprüche 1 bis 3,
**dadurch gekennzeichnet, dass**
ein Quantum-Well-Infrarot-Photodetektor verwendet wird, bei dem die Abmessungen der Quantenpunkte (10; 110; 210) in vertikaler Richtung im Bereich von 1 bis 5 nm liegen.

5. Verfahren nach Anspruch 4,
**dadurch gekennzeichnet, dass**
ein Quantum-Well-Infrarot-Photodetektor verwendet wird, bei dem die Abmessungen der Quantenpunkte (10; 110; 210) in vertikaler Richtung im Bereich von 2 bis 3 nm liegen.

6. Verfahren nach einem der voranstehenden Ansprüche,
**dadurch gekennzeichnet, dass**
ein Quantum-Well-Infrarot-Photodetektor verwendet wird, bei dem die selbstorganisierten Quantenpunkte (10; 110; 210) aus einem Material hergestellt sind, das eine deutlich größere Gitterkonstante als das Material der Barrierenschicht (9; 109; 209) besitzt.

7. Verfahren nach einem der vorangehenden Ansprüche,
**dadurch gekennzeichnet, dass**
ein Quantum-Well-Infrarot-Photodetektor verwendet wird, der mindestens zwei Quantentopfschichten (7; 107; 207) umfasst, die jeweils mindestens durch eine Barrierenschicht (9, 11; 109, 112; 209, 212) voneinander getrennt sind.

## Claims

1. Method for detecting photons having a specific wavelength by means of a quantum well infrared photodetector, wherein the method involves absorbing the photons in a quantum well structure having a quantum well layer (7; 107; 207) arranged between two barrier layers (9, 11; 109, 112; 209, 212),
- wherein the quantum well layer (7; 107; 207) is configured as an absorption layer for absorbing the photons and the absorption of photons is made possible in the direction of the normal to the quantum well layer, and
- wherein the absorption of the photons is effected by intersubband transitions in subbands of an energy band of the quantum well layer,
wherein at least one of the barrier layers (9, 11; 109, 112; 209, 212) comprises self-assembled quantum dots (10; 110; 210), the lateral extent of which is less than 100 nm and the dimensions of which in a vertical direction are not more than 10 nm, and a lateral homogeneity of the barrier layer (9; 109; 209) that is present without the quantum dots (10; 110; 210) is cancelled or modulated by the self-assembled quantum dots in such a way that, as a result, the homogeneity of the electron density distribution in the quantum well layer (7; 107; 207) in a lateral direction is cancelled or modulated and, as a result, the photons are absorbed in the direction of the normal to the quantum well layer.

2. Method according to Claim 1,
**characterized in that**
a quantum well infrared photodetector is used in which the quantum dots (10; 110; 210) have a lateral extent of less than 50 nm.

3. Method according to Claim 2,
**characterized in that**
a quantum well infrared photodetector is used in which the dimensions of the quantum dots (10; 110; 210) in a lateral direction are in the range of 5 to 15 nm.

4. Method according to Claim 1 to 3,
**characterized in that**
a quantum well infrared photodetector is used in which the dimensions of the quantum dots (10; 110; 210) in a vertical direction are in the range of 1 to 5 nm.

5. Method according to Claim 4,
**characterized in that**
a quantum well infrared photodetector is used in which the dimensions of the quantum dots (10; 110; 210) in a vertical direction are in the range of 2 to 3 nm.

6. Method according to any of the preceding claims,
**characterized in that**
a quantum well infrared photodetector is used in which the self-assembled quantum dots (10; 110; 210) are produced from a material which has a significantly greater lattice constant than the material of the barrier layer (9; 109; 209).

7. Method according to any of the preceding claims,
**characterized in that**
a quantum well infrared photodetector is used which comprises at least two quantum well layers (7; 107; 207) which are in each case separated from one another at least by a barrier layer (9, 11; 109, 112; 209, 212).

## Revendications

1. Procédé de détection de photons ayant une longueur d'onde déterminée au moyen d'un photodétecteur à infrarouge à puits quantique, dans lequel, conformément au procédé, les photons sont absorbés dans une structure de puits quantique ayant une couche de puits quantique (7 ; 107 ; 207) disposée entre deux couches barrières (9, 11 ; 109, 112 ; 209, 212),
- dans lequel la couche de puits quantique (7 ; 107 ; 207) est réalisée sous la forme d'une couche d'absorption destinée à absorber les photons et dans lequel l'absorption des photons est rendue possible dans une direction normale à la couche de puits quantique ; et
- dans lequel l'absorption des photons s'effectue par des transitions inter-sous-bandes dans des sous-bandes d'une bande d'énergie de la couche de puits quantique, dans lequel au moins l'une des couches barrières (9, 11 ; 109, 112 ; 209, 212) comprend des points quantiques (10 ; 110 ; 210) auto-organisés dont l'étendue latérale est inférieure à 100 nm ou dont les dimensions dans la direction verticale ne sont pas supérieures à 10 nm, et dans lequel une homogénéité latérale de la couche barrière (9 ; 109 ; 209) présente sans les points quantiques (10 ; 110 ; 210), des points quantiques auto-organisés, est conservée ou modulée de telle manière que l'homogénéité de la distribution de densité électronique dans la couche de puits quantique (7 ; 107 ; 207) dans la direction latérale soit conservée ou modulée et de ce fait, que les photons soient absorbés dans la direction normale à la couche de puits quantique.

2. Procédé selon la revendication 1, **caractérisé en ce qu'**on utilise un photodétecteur à infrarouge à puits quantique dans lequel les points quantiques (10 ; 110 ; 210) présentent une étendue latérale inférieure à 50 nm.

3. Procédé selon la revendication 2, **caractérisé en ce qu'**on utilise un photodétecteur à infrarouge à puits quantique dans lequel les dimensions des points quantiques (10 ; 110 ; 210) dans la direction latérale se situent dans l'intervalle de 5 à 15 nm.

4. Procédé selon l'une quelconque des revendications 1 à 3, **caractérisé en ce qu'**on utilise un photodétecteur à infrarouge à puits quantique dans lequel les dimensions des points quantiques (10 ; 110 ; 210) dans la direction verticale se situent dans l'intervalle de 1 à 5 nm.

5. Procédé selon la revendication 4, **caractérisé en ce qu'**on utilise un photodétecteur à infrarouge à puits quantique dans lequel les dimensions des points quantiques (10 ; 110 ; 210) dans la direction verticale se situent dans l'intervalle de 2 à 3 nm.

6. Procédé selon l'une quelconque des revendications précédentes, **caractérisé en ce qu'**on utilise un photodétectcur à infrarouge à puits quantique dans lequel les points quantiques auto-organisés (10 ; 110 ; 210) sont réalisés à partir d'un matériau ayant une constante de réseau sensiblement supérieure à celle du matériau de la couche barrière (9 ; 109 ; 209).

7. Procédé selon l'une quelconque des revendications précédentes, **caractérisé en ce qu'**on utilise un photodétecteur à infrarouge à puits quantique comprenant au moins deux couches de puits quantiques (7 ; 107 ; 207) qui sont respectivement séparées l'une de l'autre par au moins une couche barrière (9, 11 ; 109, 112 ; 209, 212).
